## Europäisches Patentamt
## European Patent Office
## Office européen des brevets

(19)

(11) Numéro de publication: **0 007 864**
**B1**

(12) **FASCICULE DE BREVET EUROPEEN**

(45) Date de publication du fascicule du brevet: **27.01.82**

(21) Numéro de dépôt: **79400517.3**

(22) Date de dépôt: **20.07.79**

(51) Int. Cl.³: **G 01 S 7/52**, G 01 S 3/80, G 10 K 11/34, H 03 H 15/02

(54) Formation de voies sonar par des dispositifs à transfert de charges.

(30) Priorité: **25.07.78 FR 7821968**

(43) Date de publication de la demande:
**06.02.80 Bulletin 80/3**

(45) Mention de la délivrance du brevet:
**27.01.82 Bulletin 82/4**

(84) Etats contractants désignés:
**DE GB IT NL**

(56) Documents cités:
**DE - A - 2 521 796**
**FR - A - 2 131 551**
**FR - A - 2 315 800**
**FR - A - 2 285 680**
**FR - A - 2 373 069**
**US - A - 4 012 628**
**US - A - 4 035 628**
**SIEMENS FORSCHUNG UND ENTWICK-
LUNGSBERICHTE, vol. 7, n°. 3,
(juin 1978)
Berlin. DE.
KNAUER et al.: "CCD Transversal Filters with Parallel
In/Serial Out Configuration" pages 138—142.**

(73) Titulaire: **THOMSON-CSF
173, Boulevard Haussmann
F-75360 Paris Cedex 08 (FR)**

(72) Inventeur: **Guyot, Joel
"THOMSON-CSF" - SCPI 173, bld Haussmann
F-75360 Paris Cedex 08 (FR)**
Inventeur: **Vernet, Jean-Louis
"THOMSON-CSF" - SCPI 173, bld Haussmann
F-75360 Paris Cedex 08 (FR)**

(74) Mandataire: **Trocellier, Roger et al,
"THOMSON-CSF" - SCPI 173, bld Haussmann
F-75360 Paris Cedex 08 (FR)**

Courier Press, Leamington Spa, England.

# 0 007 864

## Formation de voies sonar par des dispositifs à transfert de charges

La présente invention se rapporte à la formation de voies sonar optimisées, plus spécialement dans un sonar passif panoramique, équipé d'une base d'écoute avantageusement circulaire. La formation des voies est obtenue par la technique des "Dispositifs à transfert de Charge" appelée DTC.

Une voie préformée correspond à une écoute des bruits acoustiques autour d'une direction. Elle est obtenue par compensation des retards relatifs, par rapport à cette direction d'écoute, des signaux électriques fournis par les transducteurs formant la base d'écoute. Ces retards sont obtenus par des lignes à retard et en particulier par des registres à décalage numérique ou analogique par DTC.

L'avantage de l'utilisation des DTC par rapport aux dispositifs numériques est dû au fait que pour les DTC les signaux sont traités sous la forme d'échantillons analogiques. Il en résulte une simplification du matériel, puisque dans les systèmes numériques il faut autant de registres à décalage que de bits résultant de la quantification des amplitudes. De plus, la technique DTC permet la suppression des convertisseurs analogique-numérique et numérique-analogique qui sont coûteux, et réduisent le rapport signal sur bruit.

Dans cette technique de formation de voies DTC, les signaux reçus par les différents transducteurs formant la base d'écoute peuvent être traités en parallèle; ceci a pour inconvénient de nécessiter autant de registres à décalage DTC que de transducteurs. Il est donc plus intéressant de traiter ces signaux en série, par multiplexage.

Pour le traitement des signaux en série suivant l'art antérieur, les retards sont obtenus par des prises sur le registre à décalage DTC qui reçoit les signaux multiplexés. Ces prises fournissent des signaux échantillonnes correspondant à des transducteurs différents, et disposés de façon à fournir les retards nécessaires à la formation des voies. En fait, pour des bases courantes ayant des diamètres de l'ordre de 2m par exemple, ces retards ne peuvent être obtenus avec suffisamment de précision, pour avoir des diagrammes de réception de voies utilisables pratiquement. Ceci est dû au fait que l'obtention d'une grande précision nécessiterait des registres à décalage DTC avec un nombre de cellules trop important (supérieur à 500) pour être utilisable, compte tenu de l'"'inefficacité de transfert" des DTC.

Le dispositif suivant l'invention, utilise un traitement série dans un registre à décalage DTC, dans lequel on remplace la prise unique correspondant au retard à compenser par un certain nombre de sous-prises.

Suivant une caractéristique de l'invention, les sous-prises du registre à décalage DTC fournissent des valeurs pondérées des échantillons successifs d'une même transducteur. Ces signaux pondérés sont appliqués à un sommateur qui fournit la velour interpolée du signal de ce transducteur pour le temps de retard nécessaire à la formation des voies. La pondération est obtenue en prenant pour la cellule DTC correspondant à la sous-prise, des électrodes de commande, divisées en deux et ayant des surfaces correspondant par une méthode connue au coefficient de pondération.

Le dispositif suivant l'invention remédie ainsi à l'inconvénient de l'art antérieur en permettant d'obtenir des diagrammes de réception convenable avec un DTC de 500 cellules.

Cette interpolation est obtenue par la méthode du filtrage transversal, le dispositif suivant l'invention sera appelé filtre interpolateur.

Suivant d'autres caractéristiques de l'invention, on pourra modifier le filtre interpolateur en faisant varier les surfaces des électrodes permettant d'obtenir les pondérations, pour obtenir en outre des filtres d'optimisation par exemple de réduction de lobes secondaires du diagramme et/ou le filtre permettant de réaliser un diagramme ne changeant pas avec la fréquence.

Plus précisément, l'invention se rapporte à un dispositif de formation de voies pour sonar panoramique, conformément à la revendication.

D'autres caractéristiques et avantages de l'invention apparaîtront dans la description qui suit, d'un exemple de réalisation du dispositif, objet de l'invention donné, à l'aide des figures qui représentent:
- la figure 1, le principe de formation de voies pour un sonar panoramique;
- la figure 2, un schéma de formation de voies par DTC;
- les figures 3a et 3b, le schéma de filtres interpolateurs suivant l'invention;
- la figure 4, un dispositif de pondération par DTC.

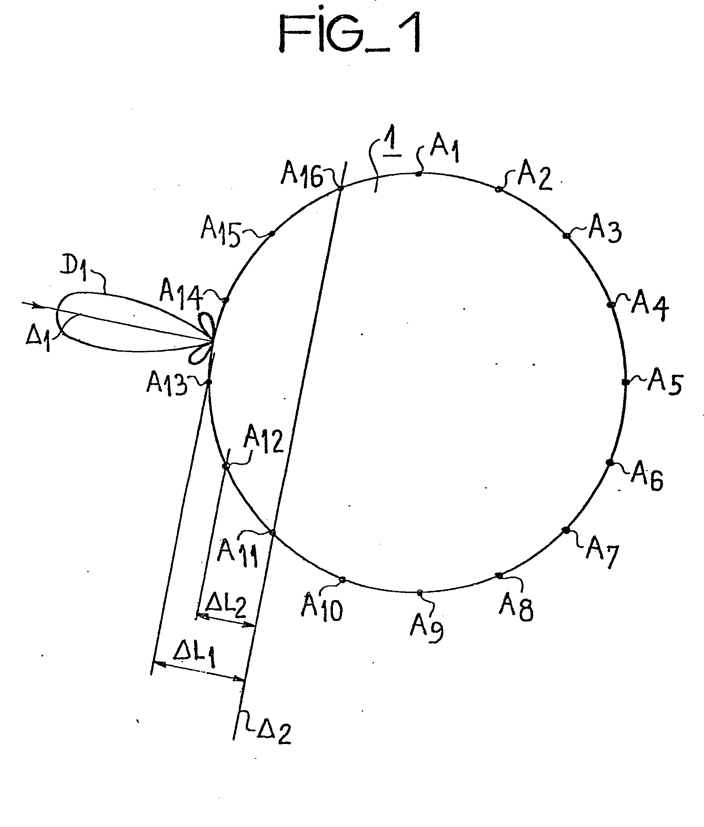

La figure 1 montre une base circulaire 1 équipée de M transducteurs A1, A2 ... AM (sur la figure 1 on a pris M = 16). Pour former une voie centrée sur la direction $\Delta_1$, on n'utilise que les signaux reçus par N transducteurs. Pour former la voie montrée sur l'exemple de la figure 1, on utilise les transducteurs A11, A12, A13, A14, A15 et A16 (N = 6). Ainsi pour une base d'écoute circulaire, ce sont les transducteurs situés sur un arc correspondant à un secteur d'ouverture 135°, qui participent à la formation d'une voie. On doit compenser les retards relatifs pour chaque transducteur. Sur la figure on a représenté les différences de marche $\Delta L_1$ et $\Delta L_2$ pour les transducteurs A12 et A13 par rapport à la droite $\Delta 2$ formée par les transducteurs A11 et A16 (M pair) où $\Delta 2$ est perpendiculaire à $\Delta 1$. Le retard $\tau l$ pour le transducteur A12 par exemple se déduit simplement de la relation: $\tau l = -\Delta L_1/C$, où C est la célérité du son dans le milieu de propagation.

Pour que le diagramme de réception D1 correspondant à la voie formée n'ait pas de lobes secondaires gênnants, on considère généralement qu'il faut compenser les retards avec un précision par exemple de l'ordre de T/8, où T est la période de la fréquence la plus élevée du spectre des signaux,

2

**0 007 864**

dans lequel se fait l'écoute. Le diagramme D1 dépend en principe de la fréquence f considérée dans ce spectre.

On sait que si une fonction a un spectre limité par la fréquence F, elle peut, sans perte d'information, être échantillonnée à des intervalles de temps 1/2F. C'est le théorème de Shannon. C'est ainsi que si F = 8000 Hz l'échantillonnage doit se faire à des intervalles de temps 62,5 $\mu$ sec.

Il est connue que pour obtenir des diagrammes convenables dans la technique de formation de voies il faut réaliser la compensation des retards avec une précision de $\mp \Delta \tau$ où $\Delta \tau$ est bien plus faible que T = 1/F par exemple $\Delta \tau$ = 1/8F. Il en résulte que pour former les voies, il faut échantillonner à des intervalles de temps, au moins quatre fois plus faibles que le critère de Shannon.

C'est ainsi que pour F = 8000 Hz, il faut échantillonner à des intervalles de temps de 15,6 $\mu$ sec. Un tel échantillonnage correspond à des DTC ayant un trop grand nombre de cellules pour être utilisables, compte tenu de l'"inefficacité de transfert". Celle-ci est due au fait, que toute le charge q d'une cellule n'est pas transférée à la suivante et qu'il reste toujours un résidu de charge $\varepsilon$q.

Pratiquement on a: $10^{-3} < \varepsilon < 10^{-4}$ et ainsi le nombre total de cellules ne doit pas dépasser 500.

Pour former les voies, on multiplexe les M signaux, échantillonnés à la fréquence $F_e$, des M transducteurs. La fréquence de multiplexage $F_{me}$ est donc donnée par $F_{me} = = M F_e$. On trouve donc que le nombre de cellules P est donné par la rélation (1): P = $\Delta \tau_{max}$ M $F_e$ où $\Delta \tau_{max}$ est le plus grand retard à considérer.

C'est ainsi que pour une base ayant un diamètre de 2,50 m, M = 32 et N = 12 on trouve: $\Delta \tau_{max}$ = 496 $\mu$ sec.

En tenant compte des considérations précédentes, on prendra $F_e \simeq$ 62,5 kHz, ce qui correspond sensiblement à huit fois la fréquence maximale de 8 kHz au lieu de deux fois, suivant le critère de Shannon. Avec ces valeurs la relation (1) donne: P $\simeq$ 993, valeur trop élevée compte tenu de a technologie actuelle. On peut montrer que d'une façon générale, ce nombre de cellules croît comme le carré de la fréquence maximale et comme le carré du diamètre de la base d'écoute du sonar.

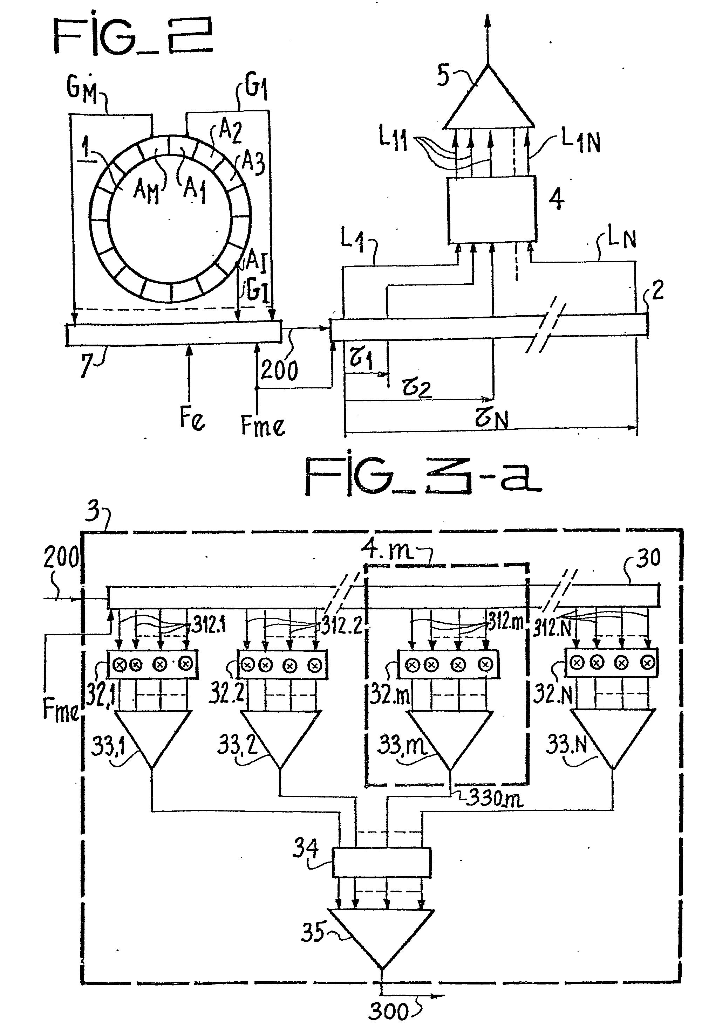

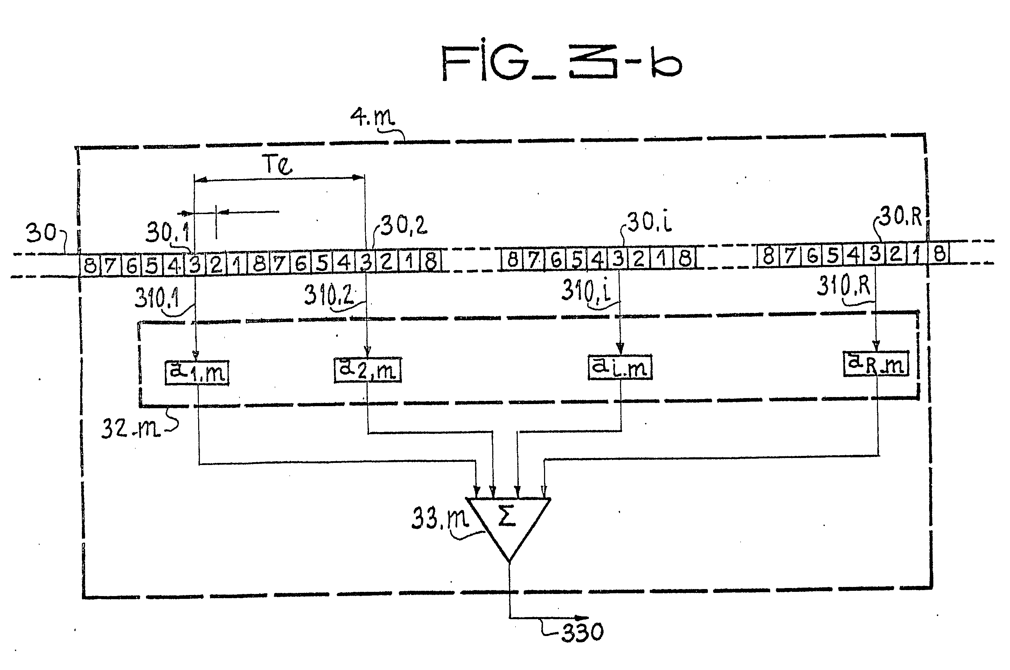

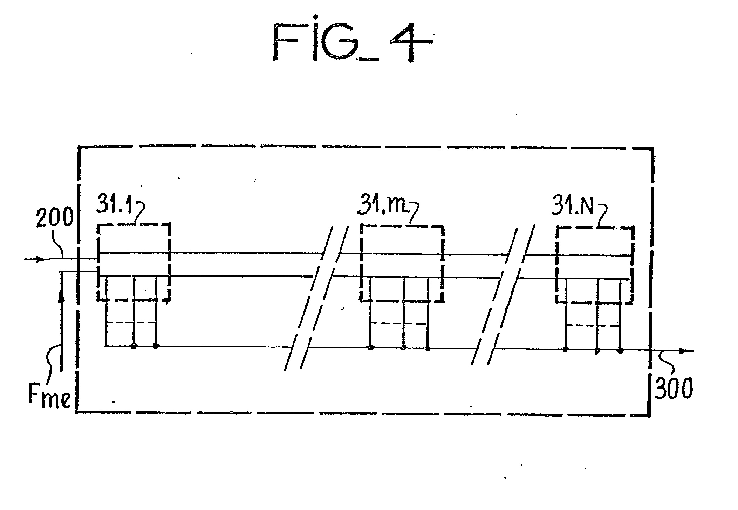

Un schéma général de formation de voies s'inspirant de l'art antérieur est montré par la figure 2. Les signaux reçus par les transducteurs A1, A2 ... AM de la base 1 sont multiplexés à la fréquence $F_{me}$. Cela peut être fait avantageusement par la technologie DTC en reliant simultanément les transducteurs A1, A2 ... AM à des cellules de registre à décalage DTC, 7 par les liaisons G1, G2, ... GI, ... GM au rythme de la fréquence d'échantillonnage $F_e$ et à transférer au rythme $F_{me}$ ces informations à un registre 2 à N prises correspondant aux retards qu'il faut introduire pour chaque transducteur. Ces prises sont reliées par des liaisons L1, L2 ... LN à des filtres 4. Les signaux filtrés sont reliés par des liaisons L11, L12, ... L1N à sommateur 5 à la sortie duquel on obtient les voies préformées. Les filtres 4 permettent de réduire les lobes secondaires et/ou de rendre les diagrammes pratiquement indépendants de la fréquence des signaux reçus.

Le schéma décrit n'est pratiquement pas utilisable compte tenu du trop grand nombre de cellules DTC nécessaires.

Suivant l'invention on réduit le nombre de cellules P par rapport à l'art antérieur en prenant $F_e \simeq$ 2, 5 F et en remplaçant la prise unique permettant de recueillir un échantillon retardé correspondant à un transducteur, par R sous-prises pour recueillir au même moment R échantillons successifs provenant d'un même transducteur.

Les figures 3a et 3b montrent les schémas de principe de la formation de voies optimisées suivant l'invention. Le signal multiplexé sortant en 200 du registre DTC 7 de la figure 2, entre dans le registre à décalage DTC, 30 de la figure 3a, en 200. Des prises multiples 312.1, 312.2, ... 312.m ... 312.N sont placées pour recueillir les échantillons avec des retards autour de $\tau 1, \tau 2 ... \tau m ... \tau N$. Il y a R sous-prises dans chacune des prises multiples telles que 312.m, qui permettent de recueillir les R échantillons successifs des signaux d'un même transducteur. Ces signaux sont pondérés en 32.1, 32.2 ... 32.m ... 32.N et sommés dans les sommateurs 33.1, 33.2 ... 33.m ... 33.N. Après sommation, ces signaux sont filtrés par les filtres 34, puis sommés par le sommateur 35 et en 300 on obtient finalement les signaux échantillonnés de voies préformées, qui défilent successivement par permutation circulaire.

L'utilisation de registres à décalage DTC permet suivant l'invention, d'obtenir la précision nécessaire pour les retards de compensation, en utilisant une fréquence d'échantillonnage plus faible et un nombre de cellules DTC plus petit, que pour l'art antérieur.

On dispose des échantillons du signal des transducteurs et soit e(t) un tel signal. A partir des échantillons $e(q T_e)$, où q est un nombre entier, on peut interpolar la valeur X(t') pour un temps t' par la relation (2):

$$X(t' \quad \sum_q a_q e (q T_e)$$

où $a_q$ sont des constantes de pondération dépendant de q et de t' et l'on montrera plus loin, comment on peut déterminer les valeurs des constantes $a_q$.

Le filtre interpolateur est montré en détail par la figure symbolique 3b. On a représenté le registre DTC 30, et les numéros portés dans les cellules correspondent aux échantillons des signaux des huit transducteurs (on a pris M = 8 pour simplifier). Le temps de passage d'un échantillon au suivant

3

**0 007 864**

correspondant à un même transducteur est $T_e = 1/F_e$ et les échantillons avancement vers la droite dans le registre 30 à la cadence du multiplexage $T_{me} = 1/F_{me}$.

L'ensemble 312.m des R sous-prises 310.1, 310.2, ... 310.i ... 310.R permet de recueillir R échantillons correspondant à un même transducteur (3 sur la figure 3b). Les surfaces des électrodes du registre sont telles que les échantillons prélevés par les sous-prises 310.1, 310.2 ... 310.i ... 310.R sont pondérés respectivement par les coefficients positifs ou négatifs $a_{1.m}$, $a_{2.m'}$ ... $a_{i.m'}$ ... $a_{R.m}$. Les signaux pondérés sont sommés par le sommateur 33.m (en réalité par la mise en parallèle des électrodes) et donnent en 300 les signal interpolé correspondant en retard $\tau_m$.

Le fonctionnement d'un filtre interpolateur s'appuie sur la propriété connue en traitement du signal sous le nom d'interpolation de Shannon. En effet, tout signal bien échantillonné peut être reconstitué à partir de ses échantillons en se basant sur la relation d'interpolation de Shannon:

$$X(t) = \sum_{n = -\infty}^{n = +\infty} e(nT_e) \cdot \frac{\sin \frac{\pi}{T_e}(t - nT_e)}{\frac{\pi}{T_e}(t - nT_e)}$$

où n est un nombre entier.

Comparée à la relation (2), on voit qu'il suffit de donner aux coefficients $a_i$, des valeurs échantillonnées dans la fonction

$$\frac{\sin x}{x}$$

Cette dernière fonction correspond à la réponse impulsionnelle d'un filtre passe-bas parfait de fréquence de coupure $F_c = F_e/2$.

Dans la réalité, cette réponse impulsionnelle est évidemment limitée dans le temps et la reconstitution de X(t) est déjà bien approchée à partir de quatre échantillons (l'interpolation avec deux échantillons correspondant à l'interpolation linéaire que l'on fait lorsque l'on joint les points d'un graphique par des droites).

Différentes méthodes peuvent être appliquées pour le calcul de ces R coefficients. Les valeurs données dans les tableau A ci-aprés, proviennent d'une optimisation en fonction du spectre du signal, en minimisant la valeur de l'écart quadratique moyen de l'erreur, lorsque signal e(t) est une sinusoïde de fréquence comprise entre O et F. Elles sont établies pour sept points possibles intermédiaires de la valeur de $e(nT_e)$ comprise entre deux instants d'échantillonnage consécutifs $e(n-1)T_e$, $e((n+1)T_e)$, ramenant ainsi l'erreur sur le retard souhaité à

$$\frac{Te}{16}$$

Il est entendu que ce tableau n'est donné qu'a titre indicatif. D'une part, le calcul peut se faire avec plus de quatre coefficients et d'autre part ces coefficients peuvent être établis pour toutes valeurs de temps comprises entre les deux échantillons $e(nT_e)$ et $e((n + 1)T_e)$. On remarquera par ailleurs que le registre à décalage 30 par suite de l'interpolation, doit être légèrement plus long que celui d'un dispositif n'employant pas l'interpolation. Cette longueur supplémentaire, proportionelle au nombre de coefficients d'interpolation, correspond à quelques périodes d'échantillonnage supplémentaires au début et à la fin du registre.

4

# 0 007 864

TABLEAU 1

$$0{,}00 \times e\left[(n-1)T_e\right] + 1{,}00 \times e(nT_e) + 0{,}00 \times e\left[(n+1)T_e\right] + 0{,}00 \times e\left[(n+2)T_e\right] = e(nT_e)$$

| | | | | |
|---|---|---|---|---|
| $-0{,}08$ | $+0{,}96$ | $+0{,}14$ | $+0{,}05$ | $= e\left(nT_e + \dfrac{1}{8} \times T_e\right)$ |
| $-0{,}14$ | $+0{,}88$ | $+0{,}30$ | $-0{,}10$ | $= e\left(nT_e + \dfrac{2}{8} \times T_e\right)$ |
| $-0{,}16$ | $+0{,}76$ | $+0{,}46$ | $+0{,}14$ | $= e\left(nT_e + \dfrac{3}{8} \times T_e\right)$ |
| $-0{,}16$ | $+0{,}62$ | $+0{,}62$ | $-0{,}16$ | $= e\left(nT_e + \dfrac{4}{8} \times T_e\right)$ |
| $-0{,}14$ | $+0{,}46$ | $+0{,}46$ | $-0{,}16$ | $= e\left(nT_e + \dfrac{5}{8} \times T_e\right)$ |
| $-0{,}10$ | $+0{,}30$ | $+0{,}88$ | $-0{,}14$ | $= e\left(nT_e + \dfrac{6}{8} \times T_e\right)$ |
| $-0{,}05$ | $+0{,}14$ | $+0{,}96$ | $-0{,}08$ | $= e\left(nT_e + \dfrac{7}{8} \times T_e\right)$ |
| $-0{,}00$ | $+0{,}00$ | $+1{,}00$ | $-0{,}00$ | $\approx e\left[(n+1)T_e\right]$ |

Suivant l'invention, on réalise également le filtre de réduction des lobes secondaires en technique DTC.

En effet, une structure telle que le montre la figure 3b représente également un filtre transversal. Si $e((n-i)T_e)$ sont les échantillons successifs du signal d'une même source à l'instant $nT_e$ et retardés de $iT_e$, et $a_i$ les coefficients de pondération, on obtient après sommation:

$$s(nT_e) = \sum_{i=0}^{i=R} e'\left((n-i)\ T_e\right) \cdot a_i \qquad (3)$$

comparable à :

$$s(t) = \int_{t-\theta}^{t} e(t-\tau)\ h(\tau)\ d\tau = e(t) * h(t) \qquad (4)$$

représentant par définition le signal de sortie $s(t)$ d'un filtre de réponse impulsionnelle $h(t)$ de durée finie $\theta$ d'un signal d'entrée $e(t)$, toutes ces fonctions du temps étant échantillonnées à $nT_e$, et ou * représente le symbole de convolution.

Les coefficients $a_i$ sont donc identifiables avec les valeurs échantillonnées de la réponse impulsionnelle caractérisant le filtre.

Il apparaît donc que, selon le nombre R des échantillons prélevés et la valeur algébrique des coefficients de pondération $a_i$, il est possible de reconstituer, avec une approximation donnée, cette réponse impulsionnelle et donc les caractéristiques d'un filtre que l'on s'est donné a priori, pour optimiser les diagrammes de rayonnement. Par exemple, il est connu que l'ont peut réduire, dans tout le spectre de fréquence des signaux reçus, les lobes secondaires du diagramme de rayonnement formé à partir d'une base circulaire.

On a vu que pour réduire les lobes secondaires du diagramme, il fallait filtrer les signaux provenant de chaque transducteur par des filtres différents 34 montrés sur la figure 3a. Or, ces filtres peuvent être réalisés en technologie DTC. L'association en série de deux filtres ayant pour réponse impulsionnelle respectivement $h_1(t)$ et $h_2(t)$ fournit un filtre résultant, de réponse impulsionnelle $h_3(t)$ telle que $h_3(t) = h_1(t) * h_2(t)$.

Il en résulte donc selon l'invention que l'on peut réaliser par un seul et même filtre transversal de réponse impulsionnelle $h_3(t)$ le filtre interpolateur de réponse impulsionnelle $h_1(t)$ et le filtre de réduction de lobes secondaires de réponse impulsionnelle $h_2(t)$.

La relation (5) peut être écrité, dans le domaine des frequences.

On sait que les fonctions de filtrage $A_1(f)$, $A_2(f)$ et $A_3(f)$ sont les transformées de Fourier des

5

réponses impulsionnelles $h_1(t)$, $h_2(t)$ et $h_3(t)$. D'après le théorème de Parseval, la relation (5) peut s'écrire: $A_3(f) = A_1(f) \cdot A_2(f)$.

On doit noter que le dispositif d'interpolation montré par la figure 3b est bien équivalent à un filtrage.

La réponse impulsionnelle $h_3(t)$ est plus étalée dans le temps que la plus longue des deux réponses impulsionnelles. Les échantillons de cette nouvelle réponse impulsionnelle devront donc être en nombre plus grand que ceux utilisés pour une simple interpolation. If faut en tenir compte pour le choix du nombre de sous-prises R.

Pour obtenir le filtre réponse impulsionnelle $h_3(t)$, il suffit de réaliser des surfaces des électrodes permettant d'obtenir les coefficients de pondération $a_{1.m}$, $a_{2.m}$, ... $a_{i.m}$, ... $a_{R.m}$ (figure 3b) correspondants et de les mettre en parallèle pour produire la sommation.

Suivant l'invention, les filtres passe-bande nécessaires pour filtrer les signaux de transducteur par une fonction $A_4(f)$ pour obtenir un diagramme indépendant de la fréquence peuvent être obtenus en pondérant les coefficients $a_{1.m}$, $a_{2.m}$, ... $a_{i.m}$, ... $a_{R.m}$, de façon à obtenir une réponse impulsionnelle $h_5(t)$ telle que $h_5(t) = h_1(t) * h_4(t)$ est la réponse impulsionnelle du filtre égaliseur en fréquence qui est la transformée de Fourier de la fonction de filtrage $A_4(f)$.

Finalement, il est avantageux de prendre des coefficients de pondération tels que les fonctions d'optimisation de lobes secondaires, l'égalisation des diagrammes en fonction de la fréquence soient cumulés avec la fonction d'interpolation temporelle.

La figure 4 représente finalement l'ensemble du DTC selon l'invention. Pour la simplification de la figure, le détail des électrodes n'a pas été représenté. Les ensembles tels que 31.m figurent cependant les électrodes de captation des charges circulantes avec leurs surfaces respectives représentatives des coefficients des différents filtres transversaux.

On constate que le DTCs réalisant la totalité des fonctions d'interpolation et d'optimisation des diagrammes de rayonnement formés est dans sa réalité considérablement plus simple que le schéma de principe de figure 3a qui le représente dans ses fonctions de composées.

En effet:

a) Chacun des filtres 34, réalisé en filtre transversal avec les DTC, a été incorporé dans le filtre interpolateur correspondant comme on l'a montre, fournissant une fonction de filtrage $A^m(f)$;

b) La sommation d'abord des signaux par des sommateurs tels que 33.m est simplement réalisée par la mise en parallèle des R électrodes d'un interpolateur puis celle des signaux issus des N interpolateurs euxmêmes est également réalisée par la mise en parallèle des sorties de ces interpolateurs ces deux opérations consistent donc à mettre toutes les électrodes (il n'y en pas à toutes les cellules mais seulement aux points de prélèvement) en parallèle.

On a ainsi montré la possibilité de réaliser des voies préformées d'un sonar passif panoramique par la technique DTC à l'aide de sous-prises multiples pour recueillir les signaux pondérés d'échantillons successifs correspondant à un transducer. Cette technique permet une interpolation at donc une bonne compensation du retard specifique du transducteur et de plus un filtrage de réduction de lobes secondaires, ainsi qu'une égalisation du diagramme de réception en fonction de la fréquence.

**Revendications**

1. Dispositif de formation de voies pour sonar panoramique, ayant un diagramme de réception optimisé utilisant un registre à décalage du type "dispositif à transfert de charge" ou DTC, les signaux de M transducteurs composant la base d'écoute du sonar étant échantillonnes, ces signaux échantillons provenant des M transducteurs ($A_1$, $A_2$, ... $A_M$) étant appliqués en série après multiplexage, à une fréquence $F_e$, à l'entrée du registre à décalage, caractérisé par le fait que le registre à décalage (30), a une structure composée d'une séries de N filtres transversaux, avec $N \leqslant M$, de fonctions de filtrage respectives $A^{(1)}(f)$, ... $A^{(m)}(f)$, ... $A^{(N)}(f)$, que chaque filtre transversal comporte R sous-prises ($a_{1m}$, $a_{2m}$, ... $a_{Rm}$) fournissant les valeurs pondérées de R échantillons successifs provenant d'un même transducteur, ce qui permet après sommation par un sommateur (33.m) d'obtenir, par interpolation à la sortie de chaque filtre transversal le signal retardé et filtré correspondant au transducteur associé, que les temps de retards de ces N signaux (330.1, ... 330.m ... 330.N) ont des valeurs prédéterminées $\tau_1$, ... $\tau_m$, ... $\tau_N$ et que les voies sont obtenues séquentiellement après sommation (35) des N signaux retardés et filtrés.

2. Dispositif de formation de voies sonar suivant la revendication 1, caractérisé par le fait que les filtres transversaux ont des coefficients de pondération tels que la fonction de filtrage du filtre de rang m soit telle que $A^{(m)}(f) = A^{(m)}_1(f)$, où $A^{(m)}_1(f)$ est la fonction de filtrage correspondant à l'interpolation des signaux d'une même transducteur pour obtenir le temps de retard prédéterminé $\tau_m$, pour la formation de voies.

3. Dispositif de formation de voies sonar suivant la revendication 1, caractérisé par le fait que les filtres transversaux ont des coefficients de pondération tels que la fonction de filtrage du filtre de rang m, $A^{(m)}(f)$, soit telle que $A^{(m)}(f) = A^{(m)}_1(f) \cdot A^{(m)}_2(f)$, où $A^m_1(f)$ est la fonction de filtrage correspondant à l'interpolation des signaux d'un mime transducteur pour obtenir le temps de retard $\tau_m$ et $A^{(m)}_2 f$ une fonction de filtrage prédéterminée pour la réduction des lobes secondaires.

4. Dispositif de formation de voies sonar suivant la revendication 1, caractérisé par le fait que les filtres transversaux ont des coefficients de pondération tels que la fonction de filtrage du filtre de rang m, $A^{(m)}$ (f), soit telle que $A^{(m)}$ (f) $= A^{(m)}_1$ (f). $A^{(m)}_4$ (f) où, $A^{(m)}_1$ (f) est la fonction de filtrage correspondant à 1' interpolation des signaux d'un même transducteur pour obtenir le temps de retard $\tau_m$ et $A^{(m)}_4$ (f) est la fonction de filtrage pour le transducteur correspondant pour que le diagramme du sonar soit indépendants de la fréquence dès la bande de fréquence des signaux.

5. Dispositif de formation de voies sonar suivant la revendication 1, caractérisé par le fait que le filtre transversal de rang m une fonction de filtrage $A^{(m)}$ (f) telle que: $A^m$ (f) $= A^{(m)}_1$(f) . $A^{(m)}_2$(f) . $A^{(m)}_4$ (f), où $A^{(m)}_1$ (f) est la fonction de filtrage correspondant à l'interpolation des signaux d'un même transducteur pour obtenir le temps de retard $\tau_m$, $A^m_2$s (f) est une fonction de filtrage prédéterminée pour la réduction des lobes secondaires et $A^{(m)}_4$ (f) la fonction de filtrage pour le transducteur correspondant, pour que le diagramme du sonar soit indépendant de la fréquence, dans la bande de fréquence des signaux.

6. Dispositif de formation de voiess sonar suivant la revendicastion 1, caractérisé par le fait que les transducteurs, disposés selon un cercle, sont multiplexés par un second dispositif à transfert de charges (7), comportant autant de cellules que de transducteurs.

7. Dispositif de formation de voies sonar selon la revendication 1, caractérisé par le fait que les coefficients de pondération des filtres transversaux sont obtenus par variation des surfaces des électrodes des DTC.

## Claims

1. Device for forming paths for panoramic sonar, having an optimized reception diagram using a shift register of "charge transfer device" or CTD type, the signals of M transducers composing the pick up base of the sonar being sampled, these sampled signals from M transducers ($A_1$, $A_2$, ... $A_M$) being applied in series, and after multiplexing at a frequency of $F_e$, to the input of the shift register, characterized by the fact that the shift register (30) has a structure composed of a series of N transverse filters, with N≤M, and respectively having filter functions $A^{(1)}$ (f), ... $A^{(m)}$ (f), ... $A^{(N)}$ (f), that each transverse filter comprises R sub-taps ($a_{1m}$, $a_{2m}$, ... $a_{Rm}$) providing weighted values of R successive samples from the same transducer, allowing to obtain after summing by a summer (33.m), and by interpolation at the output of each transverse filter, the delayed and filtered signal corresponding to the associated transducer, that the delay times of said N signals (330.1, ... 330.m, ... 330.N) have predetermined values $\tau_1$, ... $\tau_m$, ... $\tau_N$ ands that the paths are sequentially obtained after summing (35) the N delayed and filtered signals.

2. Device for forming sonar paths in accordance with claim 1, characterized by the fact that the transverse filters have weighting coefficients such that the filter function of order m is such that $A^{(m)}$ (f) $= A^{(m)}_1$ (f), wherein $A^{(m)}_1$ (f) is the filter function corresponding to the interpolation of signals of the same transducer for obtaining the predetermined delay time $\tau_m$, for forming the paths.

3. Device for forming sonar paths in accordance with claim 1, characterized by the fact that the transverse filters have weighting coefficients such that the filter function of the filter of order m, $A^{(m)}$ (f), is such that $A^{(m)}_1$ (f) . $A^{(m)}_2$ (f), wherein $A^{(m)}_1$ (f) is the filter function corresponding to the interpolation of the signals of the same transducer for obtaining the delay time $\tau_m$ and $A^{(m)}_2$ (f) is a predetermine filter function for the reduction of the secondary lobes.

4. Device for forming sonar paths in accordance with claim 1, characterized by the fact that the transverse filters have weighting coefficients such that the filter function of the filter of order m, $A^{(m)}$ (f), is such that $A^{(m)}$ (f) $= A^{(m)}_1$ (f) . $A^{(m)}_4$ wherein $A^{(m)}_1$ (f) is the filter function corresponding to the interpolation of signals of the same transducer for obtaining the delay time $\tau_m$ and $A^{(m)}_4$ (f) is the filter function for the corresponding transducer in order that the sonar diagram will be frequency independent within the frequency range of the signals.

5. Device for forming sonar paths in accordance with claim 1, characterized by the fact that the transverse filter of the order m has a filter function $A^{(m)}$ (f) such that: $A^{(m)}$ (f) $= A^{(m)}_1$ (f) . $A^{(m)}_2$ (f) . $A^{(m)}_4$ (f), wherein $A^{(m)}_1$ (f) is the filter function corresponding tos the interpolation of the signal of the same transducer for obtaining the delay time $\tau_m$, $A^{(m)}_2$ (f) is a predetermined filter function for the reduction of the secondary lobes and $A^{(m)}_4$ (f) is the filter function or the corresponding transducer in order that the sonar diagram will be frequency independent within the frequency range of the signals.

6. Device for forming sonar paths in accordance with claim 1,s characterized by the fact that the transducers, which are arranged along a circle, are multiplexed by a second charge transfer device (7) comprising as many cells as transducers.

7. Device for forming sonar paths in accordance with claim 1, characterized by the fact that the weighting coefficients of the transverse filters are obtained by variations of the electrode surface of the CTD's.

## Patentansprüche

1. Vorrichtungs zur Bildung von Wegen für Panorama-Sonargerät, mit einem optimierten Empfangsdiagramm und unter Verwendung eines Schiebereigsters vom Typ einer

7

"Ladungsverschiebevorrichtung" bzw. CTD, wobei die Signale der M die Abhörbasis des Sonargerätes bildenden Wandler probenweise abgetastet werden und diese Abtast-Signalproben aus den M Wandlern ($A_1$, $A_2$, ... $A_M$) in Reihe nach Multiplexierung mit einer Frequenz $F_e$ an den Eingang des Schieberegisters angelegt werden, dadurch gekennzeichnet, daß das Schieberegister (30) eine Struktur aufweist, die aus einer Reihe von N transversalen Filtern zusammengesetzt ist, mit $N \leqslant M$ und mit den Filterfunktionen $A^{(1)}$ (f), ... $A^{(m)}$ (f), ... $A^{(N)}$ (f), daß jedes transversale Filter R Unterabgriffe ($a_{1m}$, $a_{2m}$, ... $a_{Rm}$) umfaßt, welche gewichtete Werte der R aufeinanderfolgenden Abtastproben desselben Wandlers liefern, wodurch nach Summierung mittels eines Summierers (33.m) durch Interpolation am Ausgang jedes transversalen Filters das verzögerte und gefilterte Signal erhalten werden kann, das dem zugeordneten Wandler entspricht, daß die Verzögerungszeiten dieser N Signale (330.1, ... 330.m, ... 330.N) vorbestimmte Werte $\tau_1$ ... $\tau_m$ ... $\tau_N$ aufweisen und daß die Wege sequentiell nach Summierung (35) der N verzögerten und gefilterten Signale erhalten werden.

2. Vorrichtung zur Bildung von Sonar-Wegen nach Anspruch 1, dadurch gekennzeichnet, daß die transversalen Filter solche Wichtungskoeffizienten aufweisen, daß die Filterfunktion der Ordnung m derart ist, daß $A^{(m)}$ (f) = $A^{(m)}_1$ (f), worin $A^{(m)}_1$ (f) die Filterfunktion ist, welche der Interpolation der Signale desselben Wandlers entspricht, um zur Bildung der Wege die vorbestimmte Verzögerungszeit $\tau_m$ zu erhalten.

3. Vorrichtung zur Bildung von Sonar-Wegen nach Anspruch 1,s dadurch gekennzeichnet, daß die transversalen Filter solche Wichtungskoeffizienten aufweisen, daß die Filterfunktion des Filters der Ordnung m, $A^{(m)}$ (f), derart ist, daß $A^{(m)}_1$ (f) . $A^{(m)}_2$ (f), worin $A^{(m)}_1$ (f) die Filterfunktion ist, die der Interpolation der Signale eines selben Wandlers zur Gewinnung der Verzögerungszeit $\tau_m$ entspricht, und $A^{(m)}_2$ (f) eine vorbestimmte Filterfunktion für die Dämpfung der Sekundärzipfel ist.

4. Vorrichtung zur Bildung von Sonar-Wegen nach Anspruch 1, dadurch gekennzeichnet, daß die transveralen Filter solche Wichtungskoeffizienten haben, daß die Filterfunktionen des Filters der Ordnung m, $A^{(m)}$ (f), derart ist, daß $A^{(m)}$ (f) = $A^{(m)}_1$ (f) . $A^{(m)}_4$ (f), worin $A^{(m)}_1$ (f) die Filterfunktion ist, welche der Interpolation der Signale desselben Wandlers zum Erhalten der Verzögerungszeit $\tau_m$ entspricht, und $A^{(m)}_4$ (f) die Filterfunktion für den entsprechenden Wandler ist, damit das Sonardiagramm im Frequenzband der Signale frequenzunabhängig ist.

5. Vorrichtung zur Bildung von Sonar-Wegen nach Anspruch 1, dadurch gekennzeichnet, daß das transversale Filter der Ordnung m eine solche Filterfunktion $A^{(m)}$ (f) aufweist, daß: $A^{(m)}$ (f) = $A^{(m)}_1$ (f) . $A^{(m)}_2$ (f) . $A^{(m)}_4$ (f), worin $A^{(m)}_1$ (f) die Filterfunktion ist, welche der Interpolation der Signale desselben Wandlers zum Erhalten der Verzögerungszeit $\tau_m$ entspricht, $A^{(m)}_2$ (f) eine vorbestimmte Filterfunktion zur Dämpfungs der Sekundärzipfel und $A^{(m)}_4$ (f) die Filterfunktion für den entsprechenden Wandler ist, damit das Diagramm des Sonargeräts im Frequenzband der Signale frequenzunabhängig ist.

6. Vorrichtung zur Bildung von Sonar-Wegen nach Anspruch 1, dadurch gekennzeichnet, daß die in einem Kreis angeordneten Wandler durch eine zweite Ladungsverschiebevorrichtung (7) gemultiplext werden, welche ebensoviele Zellen wie Wandler umfaßt.

7. Vorrichtung zur Bildung von Sonar-Wegen nach Anspruch 1, dadurch gekennzeichnet, daß die Wichtungskoeffizienten der transversalen Filter durch Variation der Oberflächen der Elektroden der Ladungsverschiebevorrichtung gebildet sind.

FIG_1

0 007 864

1

# FIG_2

# FIG_3-a

FIG_3-b

# FIG_4